# EUROPEAN PATENT APPLICATION

(11) **EP 4 421 684 A1**
(43) Date of publication of application: **28.08.2024**
(21) Application number: 24160038.6
(22) Date of filing: 27.02.2024
(51) Int. Cl.: G06N 3/045, G06N 3/0475, G06T 17/30

(54) **MACHINE LEARNING TECHNIQUES FOR DIRECT BOUNDARY REPRESENTATION SYNTHESIS**

(30) Priority: 27.02.2023 US 202363487192 P; 08.01.2024 US 202418407320
(71) Applicant: Autodesk, Inc., San Francisco, CA 94105 (US)
(72) Inventor: JAYARAMAN, Pradeep Kumar, San Francisco, 94105 (US); DESAI, Nishkrit, San Francisco, 94105 (US); LAMBOURNE, Joseph George, San Francisco, 94105 (US); MORRIS, Nigel Jed Wesley, San Francisco, 94105 (US); SANGHI, Aditya, San Francisco, 94105 (US); WILLIS, Karl D. D., San Francisco, 94105 (US)
(74) Representative: Morrall, Jonathan Ian McLachlan

(57) **Abstract**

One embodiment of the present invention sets forth a technique for generating 3D CAD model representations of three-dimensional objects in boundary representation format. The technique includes generating an indexed boundary representation of the generated 3D CAD model. The indexed boundary representation includes ordered lists of vertices, edges, and faces defining the generated 3D CAD model, where the edges are encoded as references to vertices in the vertex list and the face are encoded as references to edges in the edge list. The technique further includes converting the indexed boundary representation of the generated 3D CAD model into a boundary representation of the 3D CAD model through the application of heuristic algorithms to the indexed boundary representation. The technique is optionally guided by conditional data associated with the 3D CAD model to be generated, including a 2D image, a 3D collection of volume elements, or a 3D point cloud.

## Description

### CROSS-REFERENCE TO RELATED APPLICATIONS

This application claims priority benefit of United States Patent Application titled "AZUTOREGRESSIVE MODELS FOR DIRECT B-REP SYNTHESIS," serial number 63/487,192, filed February 27, 2023. The subject matter of this related application is hereby incorporated herein by reference.

### BACKGROUND

### Field of the Various Embodiments

Embodiments of the present disclosure relate generally to machine learning and computer-aided design and, more specifically, to machine learning techniques for generating representations of three-dimensional objects in boundary representation format.

### Description of the Related Art

In the field of computer-aided design (CAD), boundary representation (B-rep) is a common format for representing three-dimensional (3D) shapes such as solid objects. In boundary representation, a solid object is defined by the limits of its volume and represented as a collection of connected surface elements that define the boundary between the object's interior and exterior points. Boundary representation synthesis refers to the automatic generation of a boundary representation of an object and is an enabling technology for design exploration, allowing automatic generation of a wide variety of 3D shape representations.

Boundary representation synthesis may be guided by a context provided as an input to the synthesis process. A context may be, for example, a two-dimensional (2D) image of an object, a 3D representation of an object as a collection of volume elements or a point cloud, or a named class to which the object belongs, such "tables" or "chairs." The ability to automatically generate boundary representations guided by a context is critical to solving a range of problems in CAD such as reverse engineering an object from imperfect 3D scan data, inpainting holes in solid models, and design synthesis from images or drawings.

Existing B-rep synthesis techniques can utilize machine learning techniques to generate boundary representations of 3D objects. These techniques often synthesize boundary representations by first producing a series of sketch and extrude CAD modeling operations using a neural network. Each of these CAD modeling operations generates a 2D sketch of a portion of an object and then extrudes the 2D sketch into a 3D volume. The volumes produced by the series of sketch and extrude CAD modeling operations are then combined into a 3D object using Boolean operations, such as addition and subtraction. The combined volumes are then converted into a boundary representation by a solid modeling kernel.

One drawback to the above techniques is that training the underlying machine learning models require training data that includes both a CAD model and the series of CAD modeling operations used to generate the CAD model. Public domain CAD model datasets that include the series of CAD modeling operations used to generate the models in the dataset are limited in quantity compared to available datasets containing CAD models alone. As a result, existing boundary representation synthesis techniques are either trained on synthetic datasets or data collected from only a few categories of CAD models. Existing B-rep synthesis techniques are further limited to sketch and extrude CAD modeling operations and cannot be easily extended to support other operations. As an example, fillet and chamfer operations are widely used in CAD to enhance objects' structural performance and ease of manufacture, but fillets and chamfers operate on boundary representation edges that are not available to the existing machine learning techniques until the predicted object has been converted into a boundary representation. Another disadvantage of existing B-rep synthesis techniques is that the sketch and extrude CAD modeling operations generated by the techniques operate with simple 2D planar curves and the techniques are not easily extensible to more complex curves or freeform modeling. Further, existing B-rep synthesis techniques are limited to producing solid models and are not suitable for producing sheet models.

As the foregoing illustrates, what is needed in the art are more effective techniques for performing boundary representation synthesis.

### SUMMARY

In one embodiment of the present invention, a computer-implemented method includes generating, using a first machine learning model, a vertex list that includes an ordered list of vertex coordinates and generating, using a second machine learning model, an edge list that includes an ordered list of edges, wherein one or more elements of the edge list include references to elements of the vertex list. The method also includes generating, using a third machine learning model, a face list that includes an ordered list of faces, wherein one or more elements of the face list include references to elements of the edge list. The method further includes generating, based on the vertex list, the edge list, and the face list, an indexed boundary representation for a 3D CAD model.

One technical advantage of the disclosed technique relative to the prior art is that the disclosed technique does not rely on training data that includes both CAD models and the series of CAD modeling operations used to generate the CAD models. As a result, there is a larger quantity of CAD model training data available suitable for training the disclosed technique. The disclosed technique also generates boundary representations directly without the need to first predict and generate a series of CAD modeling operations. Because the disclosed technique generates boundary representations directly, the disclosed technique can incorporate operations such as fillets and chamfers that require pre-existing boundary representation edges. Another advantage of the disclosed technique is that the disclosed technique is not limited to 2D planar curves. The disclosed technique supports a variety of prismatic surfaces such as planes, cylinders, cones, spheres, and tori.

### BRIEF DESCRIPTION OF THE DRAWINGS

So that the manner in which the above recited features of the various embodiments can be understood in detail, a more particular description of the inventive concepts, briefly summarized above, may be had by reference to various embodiments, some of which are illustrated in the appended drawings. It is to be noted, however, that the appended drawings illustrate only typical embodiments of the inventive concepts and are therefore not to be considered limiting of scope in any way, and that there are other equally effective embodiments.
Figure 1 illustrates a computing device 100 configured to implement one or more aspects of various embodiments.
Figure 2 is a more detailed illustration of training engine 122 of Figure 1, according to some embodiments.
Figure 3 is a more detailed illustration of a vertex model according to some embodiments.
Figure 4 is a more detailed illustration of an edge model according to some embodiments.
Figure 5 is a more detailed illustration of a face model according to some embodiments.
Figure 6 is a more detailed illustration of inference engine 124 of Figure 1, according to some embodiments.
Figure 7 is a flow diagram of method steps for unconditionally training a machine learning model to perform boundary representation synthesis, according to some embodiments.
Figure 8 is a flow diagram of method steps for conditionally training a machine learning model to perform boundary representation synthesis, according to some embodiments.
Figure 9 is a flow diagram of method steps for generating a 3D model in boundary representation format, according to some embodiments.

### DETAILED DESCRIPTION

In the following description, numerous specific details are set forth to provide a more thorough understanding of the various embodiments. However, it will be apparent to one of skilled in the art that the inventive concepts may be practiced without one or more of these specific details.

### System Overview

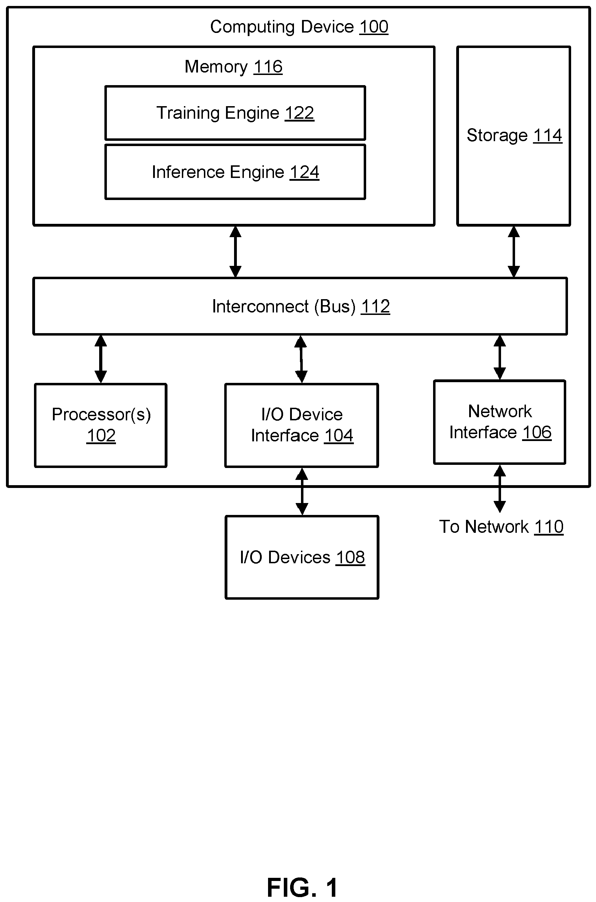

Figure 1 illustrates a computing device 100 configured to implement one or more aspects of various embodiments. In one embodiment, computing device 100 includes a desktop computer, a laptop computer, a smart phone, a personal digital assistant (PDA), tablet computer, or any other type of computing device configured to receive input, process data, and optionally display images, and is suitable for practicing one or more embodiments. Computing device 100 is configured to run a training engine 122 and an inference engine 124 that reside in a memory 116.

It is noted that the computing device described herein is illustrative and that any other technically feasible configurations fall within the scope of the present disclosure. For example, multiple instances of training engine 122 and inference engine 124 could execute on a set of nodes in a distributed and/or cloud computing system to implement the functionality of computing device 100. In another example, training engine 122 and/or inference engine 124 could execute on various sets of hardware, types of devices, or environments to adapt training engine 122 and/or inference engine 124 to different use cases or applications. In a third example, training engine 122 and inference engine 124 could execute on different computing devices and/or different sets of computing devices.

In one embodiment, computing device 100 includes, without limitation, an interconnect (bus) 112 that connects one or more processors 102, an input/output (I/O) device interface 104 coupled to one or more input/output (I/O) devices 108, memory 116, a storage 114, and a network interface 106. Processor(s) 102 may be any suitable processor implemented as a central processing unit (CPU), a graphics processing unit (GPU), an application-specific integrated circuit (ASIC), a field programmable gate array (FPGA), an artificial intelligence (Al) accelerator, any other type of processing unit, or a combination of different processing units, such as a CPU configured to operate in conjunction with a GPU. In general, processor(s) 102 may be any technically feasible hardware unit capable of processing data and/or executing software applications. Further, in the context of this disclosure, the computing elements shown in computing device 100 may correspond to a physical computing system (e.g., a system in a data center) or may be a virtual computing instance executing within a computing cloud.

I/O devices 108 include devices capable of providing input, such as a keyboard, a mouse, a touch-sensitive screen, and so forth, as well as devices capable of providing output, such as a display device. Additionally, I/O devices 108 may include devices capable of both receiving input and providing output, such as a touchscreen, a universal serial bus (USB) port, and so forth. I/O devices 108 may be configured to receive various types of input from an end-user (e.g., a designer) of computing device 100, and to also provide various types of output to the end-user of computing device 100, such as displayed digital images or digital videos or text. In some embodiments, one or more of I/O devices 108 are configured to couple computing device 100 to a network 110.

Network 110 is any technically feasible type of communications network that allows data to be exchanged between computing device 100 and external entities or devices, such as a web server or another networked computing device. For example, network 110 may include a wide area network (WAN), a local area network (LAN), a wireless (WiFi) network, and/or the Internet, among others.

Storage 114 includes non-volatile storage for applications and data, and may include fixed or removable disk drives, flash memory devices, and CD-ROM, DVD-ROM, Blu-Ray, HD-DVD, or other magnetic, optical, or solid-state storage devices. Training engine 122 and inference engine 124 may be stored in storage 114 and loaded into memory 116 when executed.

Memory 116 includes a random-access memory (RAM) module, a flash memory unit, or any other type of memory unit or combination thereof. Processor(s) 102, I/O device interface 104, and network interface 106 are configured to read data from and write data to memory 116. Memory 116 includes various software programs that can be executed by processor(s) 102 and application data associated with said software programs, including training engine 122 and inference engine 124.

In boundary representation synthesis, the one or more machine learning models generate a 3D CAD model in boundary representation format. In some embodiments, training engine 122 trains one or more machine learning models to perform boundary representation synthesis of a 3D CAD model, optionally guided by input conditioning data. Inference engine 124 executes one or more machine learning models to generate a 3D CAD model in boundary representation format, optionally guided by input conditioning data. More specifically, training engine 122 and inference engine 124 are configured to train and execute one or more machine learning models that generate a 3D CAD model in boundary representation format, optionally based on conditional data. The optional conditional data may be a class label, a 2D image, or a 3D representation using volume elements or a point cloud. The conditional data may further be any data that may be represented as or embedded into a vector, such as a textual description.

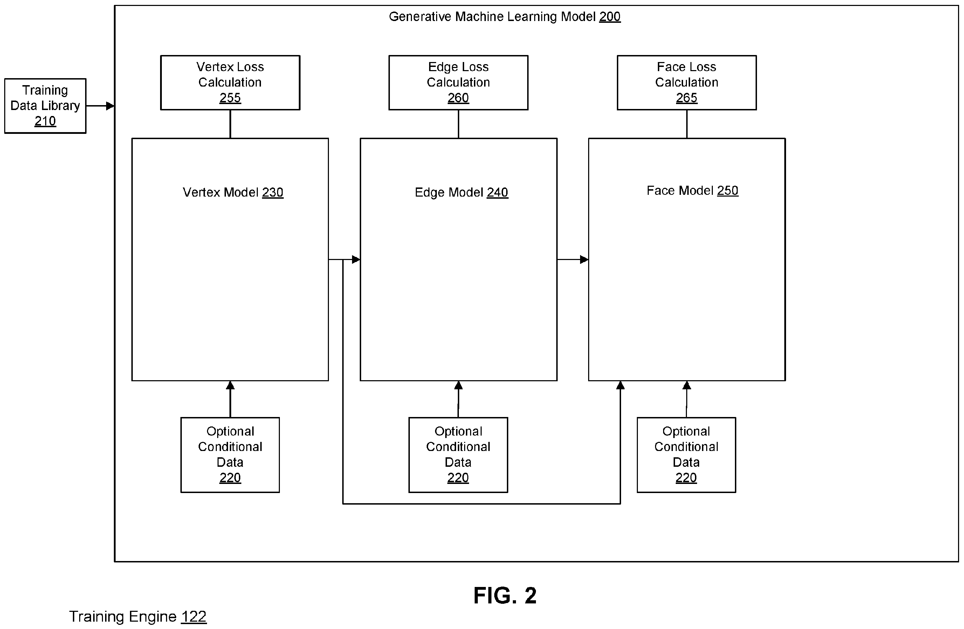

Figure 2 is a more detailed illustration of training engine 122 of Figure 1, according to some embodiments. Training engine 122 trains a generative machine learning model 200 that generates ordered lists of vertices, edges, and faces, collectively representing a 3D CAD model. As shown, training engine 122 includes a training data library 210, a vertex model 230, an edge model 240, and a face model 250. Training engine 122 trains the generative machine learning model 200 based on a vertex loss calculation 255, an edge loss calculation 260, and a face loss calculation 265. The combined trained outputs of vertex model 230, edge model 240, and face model 250 form an indexed boundary representation of the 3D model in training data library 210. The various loss calculations are based on a difference between the outputs of the vertex, edge, and face models, respectively, and ground truth data for the 3D model in training data library 210. Training engine 122 may condition the training of the vertex, edge, and face models on optional conditional data 220 that is applied to each of vertex model 230, edge model 240, and face model 250.

Training data library 210 includes 3D representations of various objects in boundary representation format. In various embodiments, the training data library 210 may further include optional conditional data associated with one or more of the various 3D representations. The optional conditional data 220 associated with a particular 3D representation may include one or more of a 2D rendering of the 3D representation, a textual class label for the 3D representation, a collection of 3D volume elements sampled from the 3D representation, or a point cloud representing points sampled from the surface of the 3D representation. The optional conditional data 220 may further include any features associated with the 3D representation that can be expressed as a vector, including a textual description of the 3D representation.

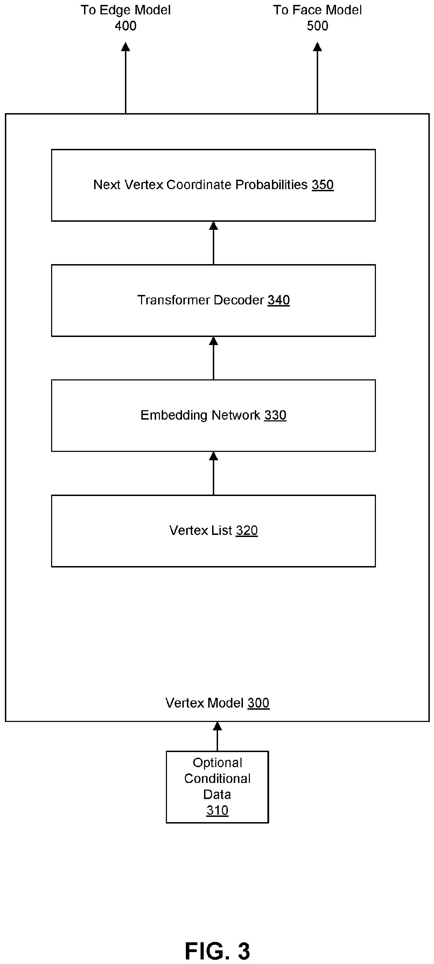

Generative machine learning model 200 includes a vertex model 230 that iteratively generates an ordered list of vertices for a generated 3D CAD model by sampling from a calculated probability distribution over a set of possible vertex values. Vertex model 230 is an autoregressive machine learning model that iteratively predicts a next vertex value in the ordered list of vertices based on optional conditional data 220 and previously predicted vertex values in the ordered list of vertices. During each iteration of training, training engine 122 compares the predicted next vertex value with ground truth data from training data library 210 and performs a cross-entropy vertex loss calculation 255 to generate a vertex loss. The cross-entropy loss represents a difference between the probability distribution calculated by the vertex model and the ground truth data from the training data set. Training engine 122 trains vertex model 230 using a teacher forcing method where, at each training iteration, vertex model 230 predicts the next vertex value based on ground truth data from training data library 210 rather than on the vertex values previously predicted by vertex model 230. Vertex model 230 is discussed in more detail in the description of Figure 3 below.

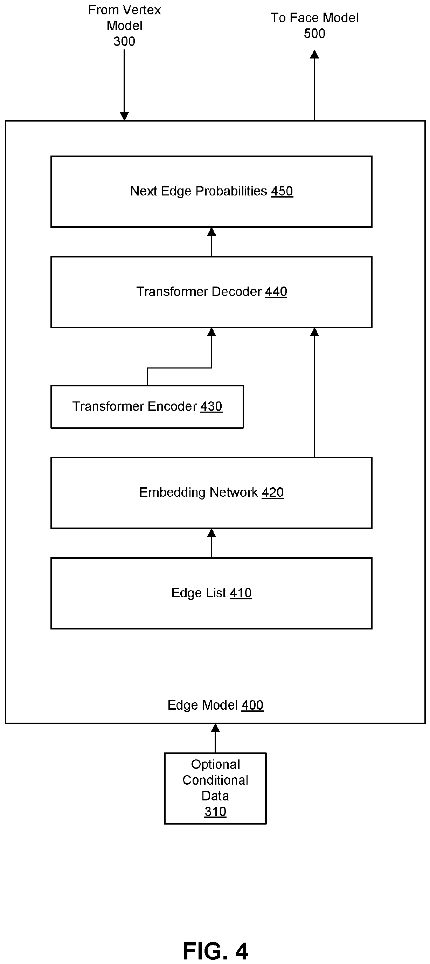

Generative machine learning model 200 includes an edge model 240 that iteratively generates an ordered list of edges for a generated 3D CAD model by sampling from a calculated probability distribution over a set of possible edge values. Edge model 240 samples from the calculated probability distribution using a one-level pointer network as described below in the description of Figure 4. Edge model 240 is an autoregressive machine learning model that iteratively predicts a next edge value in the ordered list of edges based on previously predicted edge values in the ordered list of edges and optional conditional data 220. During each iteration of training, training engine 122 compares the predicted next edge value with ground truth data from training data library 210 and performs a cross-entropy edge loss calculation 260 to generate an edge loss. Training engine 122 trains edge model 240 using a teacher forcing method where, at each training iteration, edge model 240 predicts the next edge value based on ground truth data from training data library 210 rather than on the edge values previously predicted by edge model 240. Edge model 240 is discussed in more detail in the description of Figure 4 below.

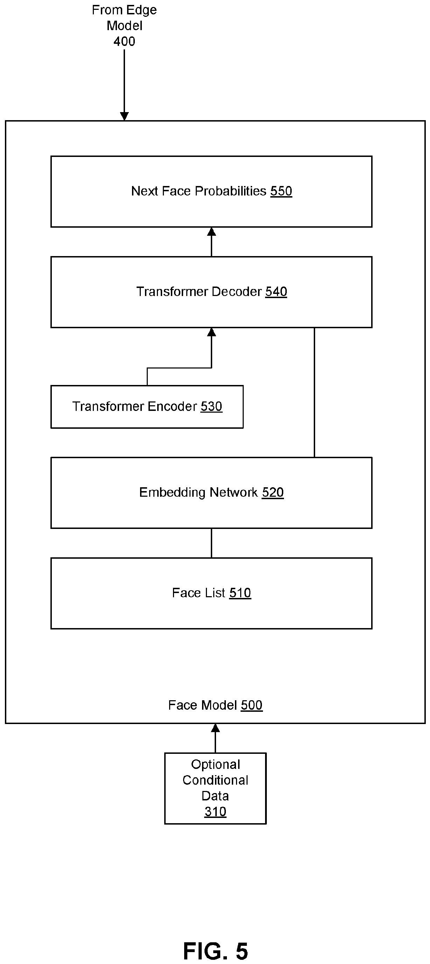

Generative machine learning model 200 includes a face model 250 that iteratively generates an ordered list of faces for a generated 3D CAD model by sampling from a calculated probability distribution over a set of possible face values. Face model 250 samples from the calculated probability distribution using a two-level pointer network as described below in the description of Figure 5. Face model 250 is an autoregressive machine learning model that iteratively predicts a next face value in the ordered list of faces based on optional conditional data 220 and previously predicted face values in the ordered list of faces. During each iteration of training, training engine 122 compares the predicted next face value with ground truth data from training data library 210 and performs a cross-entropy face loss calculation 265 to generate a face loss. Training engine 122 trains face model 250 using a teacher forcing method where, at each training iteration, face model 250 predicts the next face value based on ground truth data from training data library 210 rather than on the face values previously predicted by face model 250. Face model 250 is discussed in more detail in the description of Figure 5 below.

Training engine 122 may train generative machine learning model 200 to generate 3D representation without optional conditional data 220. Training engine 122 trains generative machine learning model 200 solely on the 3D representations of objects included in training data library 210 and does not apply optional conditional data 220 to vertex model 230, edge model 240, or face model 250. When training generative machine learning model 200 without optional conditional data 220, training engine 122 may decouple vertex model 230, edge model 240, and face model 250, as training each model relies solely on ground truth data from training data library 210, and training engine 122 does not apply results generated by one of vertex model 230, edge model 240, and face model 250 to the other models. By decoupling vertex model 230, edge model 240, and face model 250, training engine 122 may train each of vertex model 230, edge model 240, and face model 250 independently. Training engine 122 may independently train vertex model 230, edge model 240, and face model 250 simultaneously or sequentially.

When training generative machine learning model 200 without optional conditional data 220, training engine 122 retrieves a 3D object from training data library 210. Each 3D object in training data library 210 is represented in boundary representation format and includes the vertices, edges, and faces that define the 3D object. Training engine 122 trains vertex model 230 based on the ground truth vertex data for the 3D object. Training engine 122 further trains edge model 240 based on the ground truth vertex and edge data for the 3D object, and trains face model 250 on the ground truth vertex, edge, and face data for the 3D object. Training engine 122 calculates a cross-entropy loss for each of the vertex, edge, and face models (loss calculations 255, 260, and 265, respectively) and terminates training each of the vertex, edge, and face models after a fixed number of epochs, or if the calculated loss of the validation set stagnates (i.e., early stopping).

Training engine 122 may train generative machine learning model 200 while applying optional conditional data 220. Training engine 122 trains generative machine learning model 200 on the 3D representations of objects included in training data library 210, as well as optional conditional data 220 associated with each of the 3D representations included in training data library 210. For each object included in training data library 210, optional conditional data 220 associated with the object may include a textual class label, a 2D rendering of the object, or a 3D representation of the object as a collection of volume elements or a point cloud. Optional conditional data 220 may further include any features of the object that can be expressed as a vector, for example a textual description of the object. Training engine 122 applies optional conditional data 220 to each of vertex model 230, edge model 240, and face model 250 during training. When training generative machine learning model 200 with optional conditional data 220, training engine 122 trains vertex model 230, edge model 240, and face model 250 together rather than decoupling the vertex, edge, and face models and training the models independently.

During training using optional conditional data 220, training engine 122 retrieves a 3D object from training data library 210. Each 3D object in training data library 210 is represented in boundary representation format and includes the vertices, edges, and faces that define the 3D object. Training engine 122 further retrieves optional conditional data 220 associated with the 3D object. Training engine 122 converts the optional conditional data 220 into embedding vectors and applies the optional conditional data 220 to each of vertex model 230, edge model 240, and face model 250.

Training engine 122 trains vertex model 230 based on the ground truth vertex data for the 3D object and optional conditional data 220. Training engine 122 further trains edge model 240 based on the ground truth edge data for the 3D object, the vertex list generated by vertex model 230, and optional conditional data 220. Training engine 122 trains face model 250 on the ground truth face data for the 3D object, as well as the edge list generated by edge model 240, the vertex list generated by vertex model 230, and optional conditional data 220. Training engine 122 calculates a cross-entropy loss for each of the vertex, edge, and face models (loss calculations 255, 260, and 265, respectively) and terminates training each of the vertex, edge, and face models when the calculated loss for the model stagnates during the validation test or a predetermined number of epochs have elapsed.

Figure 3 is a more detailed illustration of a vertex model according to some embodiments. Vertex model 300 is an autoregressive machine learning model that iteratively generates an ordered list ***V^{seq}*** of vertices for a generated 3D CAD model. As shown, vertex model 300 includes vertex list 320, embedding network 330, transformer decoder 340, and next vertex coordinate probabilities 350. Vertex model 300 optionally receives optional conditional data 310 and transmits the generated list of vertices ***V*** to edge model 400 and face model 500 discussed below.

Vertex list 320 is an ordered list of tokens, each token representing one coordinate (x, y, or z) of a generated vertex or an End of Sequence (EOS) token. The tokens are ordered such that the first token is an x-coordinate of a given vertex, the second token is a y-coordinate of the given vertex, and the third token is a z-coordinate of the given vertex. This ordering continues for subsequent vertices, with each subsequent sequential triplet of tokens representing the x, y, and z coordinates of a single vertex. The EOS token may only appear at the end of vertex list 320 and terminates vertex list 320. Each coordinate value in vertex list 320 is a quantized value representing one of a range of possible x, y, or z coordinate values. As an example, the disclosed technique may quantize each range of possible x, y, and z coordinate values as a six-bit value, giving 2⁶ = 64 possible values for each of the x, y, and z coordinates of a vertex. In operation, vertex model 300 iteratively extends vertex list 320, adding selected vertex coordinates until vertex model 300 predicts an EOS token as the next token in vertex list 320 rather than a vertex coordinate. Vertices are stored in vertex list 320 in lexicographical order, sorted first by the vertices' z-coordinates, then by the vertices' y-coordinates, and finally by the vertices' z-coordinates.

Embedding network 330 receives embedding information from vertex list 320. For each token in vertex list 320, embedding network 330 learns three types of embeddings. The first type of embedding is a coordinate embedding indicating whether the token is an x, y, or z-coordinate of a vertex. The second type of embedding is a positional embedding indicating the vertex index to which the token belongs in ordered vertex list 320, and the third type of embedding is a value embedding that encodes the quantized value of the x, y, or z-coordinate.

Embedding network 330 further optionally receives embedding information from optional conditional data 310. In various embodiments where optional conditional data 310 is a class label, embedding network 330 learns the class label as a start-of-sequence embedding.

Embedding network 330 transmits the learned embeddings to transformer decoder 340. Transformer decoder 340 is an autoregressive neural network that models the next output vertex token *vₜ* in list ***V^{seq}*** given the previous values of ***V^{seq}*** up to step *t-*1 and the learned embeddings from embedding network 330.

Transformer decoder 340 further optionally receives embedding information from optional conditional data 310. In various embodiments where optional conditional data 310 is a 2D image, a collection of volume elements, or a point cloud, transformer decoder 340 learns an embedding based on a flattened vector representation of the 2D image, collection of volume elements, or point cloud. In alternative embodiments, transformer decoder 340 can learn an embedding for any optional conditional data 310 that can be expressed as a vector, such as a textual description.

Transformer decoder 340 predicts next vertex coordinate probabilities 350 in the form of logits over all possible vertex coordinate values for the next token *vₜ,* building a probability distribution over quantized values serving as indices to vertex coordinate values. Transformer decoder 340 may also select the EOS token as the next token *vt* and terminate the prediction of further tokens.

At each time step t, vertex model 300 may mask logits generated by transformer decoder 340 that do not represent valid values for the token *vₜ.* If the vertex token being generated is a z-coordinate, then the generated z-coordinate must be greater than or equal to the previous z-coordinate that was generated. If the vertex token being generated is a y-coordinate, and the last two z-coordinates were equal, then the generated v-coordinate must be greater than or equal to the previous y-coordinate that was generated. If the vertex token being generated is an x-coordinate, and the last two z-coordinates and y-coordinates were equal, then the generated x-coordinate must be greater than the previous x-coordinate that was generated. Finally, the EOS token may only appear after a z-coordinate. Vertex model 300 assigns a small negative value (e.g., -10⁹) to invalid logits in next vertex coordinate probabilities 350 and distributes the next token probabilities among the remaining valid logits.

Vertex model 300 performs nucleus sampling from the logits generated by transformer decoder 340 and assigns the sampled value to the token *vₜ.* Vertex model 300 continues to iteratively add tokens to list ***V^{seq}*** until vertex model 300 predicts the EOS marker for the current token. Vertex model 300 transmits the ordered vertex list ***V*** to edge model 400 and face model 500.

During training, training engine 122 trains vertex model 300 using a teacher forcing method as described above in the description of Figure 2. At each training iteration, vertex model 300 predicts the next vertex value based on ground truth data from training data library 210 rather than on the vertex values previously predicted by vertex model 300.

Figure 4 is a more detailed illustration of an edge model according to some embodiments. Edge model 400 is an autoregressive machine learning model that iteratively generates an ordered list ***ε^{seq}*** of edges for a generated 3D CAD model. As shown, edge model 400 includes edge list 410, embedding network 420, transformer encoder 430, transformer decoder 440, and next edge probabilities 450. Edge model 400 optionally receives optional conditional data 310, receives the generated list of vertices ***V*** from vertex model 300 and transmits the generated list of edges ***ε*** to face model 500 discussed below.

Edge list 410 is an ordered list of tokens, each token including an index into the vertex list 320 to represent a vertex included in an edge. Edge list 410 also includes one or more new edge tokens representing the beginning of a new edge and an end of sequence (EOS) token marking the end of the list. The tokens in edge list 410 are ordered such that for each edge, the tokens representing vertex indices for the edge are first sorted in ascending order, and then the edges in edge list 410 are sorted such that the edges with the lowest vertex indices appear first in edge list 410. In operation, edge model 400 iteratively extends an output edge sequence ***ε^{seq}***, adding vertex indices and new edge tokens until edge model 400 predicts an EOS token and terminates ***ε^{seq}**.*

Embedding network 420 receives embedding information from edge list 410. For each token in edge list 410, embedding network 420 learns a positional embedding indicating the position of each token in ordered edge list 410. Embedding network 420 further optionally receives embedding information from optional conditional data 310. The optional conditional data 310 applied to vertex model 300 is also applied to edge model 400, as well as to face model 500 discussed below. In various embodiments where optional conditional data 310 is a class label, embedding network 420 learns the class label as a start-of-sequence embedding. Embedding network 420 transmits the learned positional embeddings and optional conditional embeddings to transformer decoder 440.

Transformer encoder 430 receives vertex list ***V*** from vertex model 300 and generates vertex values for the vertices in vertex list ***V*.** Each of the previous values of ***ε^{seq}*** is an index into the vertex list ***V*.** For each of the previous values of ***ε^{seq}**,* transformer encoder 430 retrieves the value in ***ε^{seq}*** as a vertex reference pointer. Transformer encoder 430 dereferences the vertex reference pointer to obtain vertex coordinate values for a vertex in ***V*.** For each vertex, transformer encoder 430 generates a vertex value based on the vertex coordinate values. Transformer encoder 430 concatenates (combines) the generated vertex values associated with each edge in ***ε^{seq}*** to generate an edge value for the edge. Each edge token in edge list ***ε^{seq}**,* which corresponds to the index of a vertex, is thereby encoded by the embedding of that vertex. Transformer encoder 430 processes the edge values to generate edge embedding vectors for the edge tokens in edge list ***ε^{seq}**.* Transformer encoder 430 further concatenates the edge embedding vectors with embeddings representing the new edge and EOS tokens and applies the concatenated embeddings to transformer decoder 440 as an input edge list. In various embodiments, transformer encoder 430 performs concatenation using a multilayer perceptron.

Transformer decoder 440 is an autoregressive neural network that models the next output edge token *eₜ* in output edge list ***ε^{seq}*** given vertices ***V*,** the previous values of ***ε^{seq}*** up to step t-1, and the learned embeddings from embedding network 420 and transformer encoder 430. Transformer decoder 440 further optionally receives embedding information from optional conditional data 310. In various embodiments where optional conditional data 310 is a 2D image, a collection of volume elements, or a point cloud, transformer decoder 440 learns a conditional embedding based on a flattened vector representation of the 2D image, collection of volume elements, or point cloud. In alternative embodiments, transformer decoder 440 can learn a conditional embedding for any optional conditional data 310 that can be expressed as a vector, such as a textual description.

Transformer decoder 440 predicts next edge probabilities 450 in the form of logits over all possible vertex indices in ***V*** for the next token *eₜ*. Transformer decoder 440 includes a one-level pointer network. A pointer network generates an output value that corresponds to a position in input edge list 410. As discussed above, edge list 410 also includes new edge tokens and an EOS token. Therefore, transformer decoder 440 may also select the new edge token as the next token *eₜ* to denote the beginning of a new edge in the generated edge list or may select the EOS token as the next token *eₜ* and terminate the prediction of further tokens. Transformer decoder 440 generates an output pointer vector, and edge model 400 applies a dot product operation to the output pointer vector and a concatenation of the edge, new edge, and EOS embeddings. Edge model 400 normalizes the result of the dot product operation to generate next edge probabilities 450 as a distribution of probabilities over the embeddings. The pointer network of transformer decoder 440 generates an output edge value that is an index pointing to a value in the vertex list ***V*.**

At each time step t, edge model 400 may mask logits generated by transformer decoder 440 that do not represent valid values for the token *eₜ*. The EOS and new edge tokens cannot appear as the first token and the new edge token cannot be repeated consecutively. If the previous token was a new edge token, then the current token must be greater than or equal to the first token in the previous edge to respect the sorted ordering of the edges. If the previous token was not a new edge token, then the current token has to be greater than the previous token to respect the sorted order of tokens within each edge. A new edge or EOS token can only appear after two or three edge tokens have been generated. This guarantees that each edge is defined as a line or an arc. Edge model 400 assigns a small negative value (e.g., -10⁹) to invalid logits in next edge probabilities 450 and distributes the next token probabilities among the remaining valid logits.

Edge model 400 performs nucleus sampling from the probabilities generated by transformer decoder 440 and assigns the sampled value to the token *eₜ*. Edge model 400 continues to iteratively add tokens to list ***ε^{seq}*** until edge model 400 selects the EOS marker for the current token. Edge model 400 transmits the ordered edge list ***ε*** to face model 500. As noted above, each token e*ₜ* in edge list ***ε^{seq}*** except new edge tokens and the EOS token is an index into vertex list ***V*,** such that each edge is encoded by the vertices that make up the edge.

During training, training engine 122 trains edge model 400 using a teacher forcing method as described above in the description of Figure 2. At each training iteration, edge model 400 predicts the next edge token based on ground truth data from training data library 210 rather than on the edge tokens previously predicted by edge model 400.

Figure 5 is a more detailed illustration of a face model according to some embodiments. Face model 500 is an autoregressive machine learning model that iteratively generates an ordered list 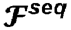 of faces for a generated 3D CAD model. As shown, face model 500 includes face list 510, embedding network 520, transformer encoder 530, transformer decoder 540, and next face probabilities 550. Face model 500 optionally receives optional conditional data 310 and receives the generated list of vertices ***ε*** from edge model 400.

Face list 510 is an ordered list of tokens, each token including an index into the edge list 410 to represent an edge included in a face. Face list 510 also includes one or more new face tokens representing the beginning of a new face and an end of sequence (EOS) token marking the end of the list. The tokens in face list 510 are ordered such that for each face, the tokens representing edge indices for the face are first sorted in ascending order, and then the faces in face list 510 are sorted such that the faces with the lowest edge indices appear first in face list 510. In operation, face model 500 iteratively extends 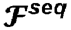 , adding edge indices and new face tokens until face model 500 terminates 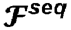 with an EOS token.

Embedding network 520 receives embedding information from face list 510. For each token in face list 510, embedding network 520 learns a positional embedding indicating the position of each token in ordered face list 510.

Embedding network 520 further optionally receives embedding information from optional conditional data 310. The optional conditional data 310 applied to vertex model 300 and edge model 400 is also applied to face model 500. In various embodiments where optional conditional data 310 is a class label, embedding network 520 learns the class label as a start-of-sequence embedding. Embedding network 520 transmits the learned positional embeddings and optional conditional embeddings to transformer decoder 540.

Transformer encoder 530 receives vertex list ***V*** from vertex model 300 and edge list ***ε*** from edge model 400. Each of the previous values of 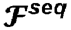 is an index into the edge list ***ε***. For each of the previous values of 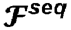 , transformer encoder 530 retrieves the value in 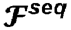 as an edge reference pointer into edge list ***ε***. Transformer encoder 530 dereferences the edge reference pointer to obtain a vertex reference pointer into the vertex list 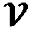 . Transformer encoder 530 dereferences the vertex reference pointer to obtain vertex coordinate values for a vertex in 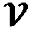 **.** For each vertex in an edge, transformer encoder 530 generates a vertex value. Transformer encoder 530 concatenates (combines) the generated vertex values to generate an edge value. Transformer encoder 530 generates edge values for each edge that forms a boundary of a face in 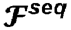 and concatenates the edge values to generate a face value. Each face token in face list 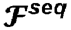 is thereby encoded by the values of the edges that form the face. Transformer encoder 530 processes the face tokens to generate face embedding vectors. The face embedding vectors are further concatenated with embeddings representing the new face and EOS tokens and applied to transformer decoder 540. In various embodiments, transformer encoder 530 performs concatenation using a multilayer perceptron.

Transformer decoder 540 is an autoregressive neural network that models the next output edge token *fₜ* in output face list 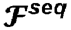 given vertices 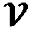 , edges 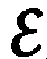 , the previous values of 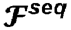 up to step t-1 and the learned embeddings from embedding network 520 and transformer encoder 530. Transformer decoder 540 further optionally receives embedding information from optional conditional data 310. In various embodiments where optional conditional data 310 is a 2D image, a collection of volume elements, or a point cloud, transformer decoder 540 learns a conditional embedding based on a flattened vector representation of the 2D image, collection of volume elements, or point cloud. In alternative embodiments, transformer decoder 540 can learn a conditional embedding for any optional conditional data 310 that can be expressed as or embedded into a vector, such as a textual description.

Transformer decoder 540 predicts next face probabilities 550 in the form of logits over all possible edge indices in ***ε*** for the next token fr. Transformer decoder 540 includes a two-level pointer network. The two-level pointer network generates an output value that corresponds to an index in ***ε*** and then defines the edges hierarchically based on the edge pointers in ***ε*** that point to the vertices in ***V*** that form the edge. Transformer decoder 540 may also select the new face token as the next token *fₜ* to denote the beginning of a new face in the generated model or may select the EOS token as the next token *fₜ* and terminate the prediction of further tokens. Transformer decoder 540 generates an output pointer vector, and face model 500 applies a dot product operation to the output pointer vector and the concatenated face, new face, and EOS embeddings. Face model 500 normalizes the result of the dot product operation to generate next face probabilities 550 as a distribution of probabilities over the embeddings. The pointer network of transformer decoder 540 generates an output face value in 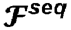 that is an index pointing to a value in the edge list ***ε***, a new face token, or an EOS token.

At each time step t, face model 500 may mask logits generated by transformer decoder 540 that do not represent valid values for the token *fₜ*. The EOS and new face tokens cannot appear as the first token and the new face token cannot be repeated consecutively. If the previous token was a new face token, then the current token must be greater than or equal to the first token in the previous face to respect the sorted ordering of the faces. If the previous token was not a new face token, then the current token must be greater than the previous token to respect the sorted order of tokens within each face. A new face or EOS token can only appear after at least two face tokens have been generated. This guarantees that each face has at least two edges to make it closed (e.g., two arcs). An edge index can only be used twice in the sampled face tokens. This ensures that an edge can at most be shared by two faces, and helps prevents non-manifold results. Face model 500 assigns a small negative value (e.g., -10⁹) to invalid logits in next face probabilities 550 and distributes the next token probabilities among the remaining valid logits.

Face model 500 performs nucleus sampling from the probabilities generated by transformer decoder 540 and assigns the sampled value to the token *fₜ*. Face model 500 continues to iteratively add tokens to list 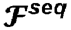 until face model 500 selects the EOS marker for the current token. As noted above, each token *fₜ* in face list 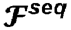 except new face tokens and the EOS token is an index into edge list ***ε***, such that each face is encoded by the edges that make up the face.

During training, training engine 122 trains face model 500 using a teacher forcing method as described above in the description of Figure 2. At each training iteration, face model 500 predicts the next face token based on ground truth data from training data library 210 rather than on the face tokens previously predicted by face model 500.

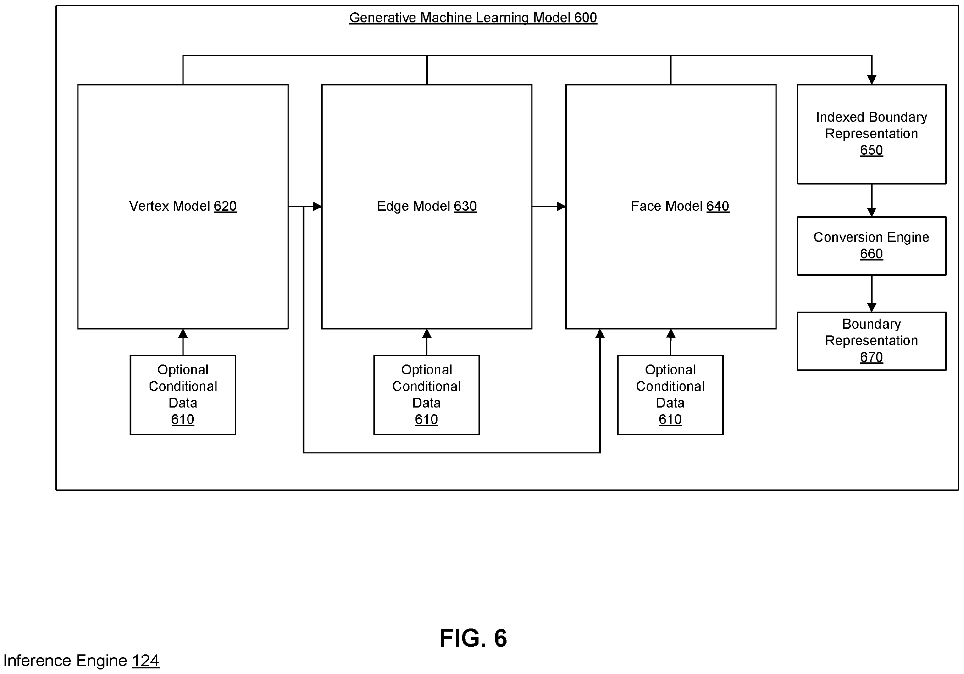

Figure 6 is a more detailed illustration of inference engine 124 of Figure 1, according to some embodiments. Inference engine 124 generates a 3D CAD model of an object in boundary representation format. As shown, generative machine learning model 600 of inference engine 124 includes a vertex model 620, an edge model 630, a face model 640 and optional conditional data 610. Generative machine learning model 600 generates an indexed boundary representation 650 of a generated 3D CAD model. Inference engine 124 converts indexed boundary representation 650 into a boundary representation 670 of the generated 3D CAD model via a conversion engine 660.

Generative machine learning model 600 includes a vertex model 620 that iteratively generates an ordered list of vertices ***V*** for a generated 3D CAD model by sampling from a calculated probability distribution over a set of possible vertex values. Vertex model 230 is an autoregressive machine learning model that iteratively predicts a next vertex value in the ordered list of vertices based on optional conditional data 610 and previously predicted vertex values in the ordered list of vertices.

Generative machine learning model 600 includes an edge model 630 that iteratively generates an ordered list of edges ***ε*** for a generated 3D CAD model by sampling from a calculated probability distribution over a set of possible edge values. Edge model 630 is an autoregressive machine learning model that iteratively predicts a next edge value in the ordered list of edges based on optional conditional data 610, the list of vertices ***V*** generated by vertex model 620, and previously predicted edge values in the ordered list of edges ***ε***.

Generative machine learning model 600 includes a face model 640 that iteratively generates an ordered list of faces 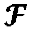 for a generated 3D CAD model by sampling from a calculated probability distribution over a set of possible face values. Face model 640 is an autoregressive machine learning model that iteratively predicts a next face value in the ordered list of faces 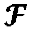 based on optional conditional data 610, the vertex and edge lists ***V*** and ***ε*** generated by vertex model 620 and edge model 630 respectively, and previously predicted face values in the ordered list of faces 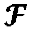 .

Inference engine 124 combines the ordered vertex, edge, and face lists ***V*, *ε***, and 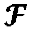 to form 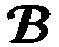 = { 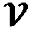 , 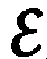 *,* 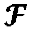 ), an indexed boundary representation 650 of the generated 3D CAD model. Inference engine 124 converts indexed boundary representation 650 into boundary representation 670 by applying conversion engine 660 to the indexed boundary representation 650.

Boundary representation (B-rep) is a method for representing a 3D shape by defining the limits of its volume. A solid is represented as a collection of connected surface elements, which define the boundary between interior and exterior points. In conversion engine 660, each point in ***V*** is potentially a vertex in the boundary representation of the 3D CAD model. Conversion engine 660 dereferences each edge *E* in ***ε*** and collects the list of points defining the edge and the geometry of the edge. Conversion engine 660 generates a pair of boundary representation vertices in boundary representation 670 from the endpoints of the edge E if the boundary representation vertices do not already exist. Conversion engine 660 further generates a topological boundary representation edge in boundary representation 670 connecting the boundary representation vertices. The curve geometry of the boundary representation edge is determined by the cardinality of edge *E.* If edge *E* includes only two points, then the boundary representation edge type is a line. If edge *E* includes three points, then the boundary representation edge type is an arc. If edge *E* includes exactly four points, then the boundary edge representation is a cubic Bezier curve, and if edge *E* includes exactly five points, then the boundary edge representation is a quintic Bezier curve.

Conversion engine 660 analyzes each face *F* in 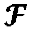 and collects the list of edges bounding the face. In a boundary representation, the edges bounding a face may either be part of an outer wire running in a counterclockwise direction that defines the visible part of the face's geometry, or part of one or more inner wires running in a clockwise direction that define the hidden portions (holes) in the face's geometry. Conversion engine 660 generates wires in boundary representation 670 for each face *F* in 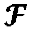 by connecting the edges bounding the face into one or more closed loops. Conversion engine 660 defines a vertex-edge graph where each boundary representation edge and its vertices are graph nodes connected by directed edges. Conversion engine 660 analyzes the vertex-edge graph and detects cycles in the graph. Each cycle in the vertex-edge graph defines a wire, and conversion engine 660 defines the largest wire as the counterclockwise visible wire. Conversion engine 660 assigns a clockwise direction to the other wires and defines the other wires to be holes in the face's geometry.

Conversion engine 660 generates a boundary representation surface type for each face *F* in 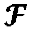 . The boundary representation surface type for each face *F* may be a portion of a plane, cylinder, cone, sphere, torus, or B-spline surface. Conversion engine 660 analyzes the boundary representation curves defining the face and selects the simplest boundary representation surface type that is consistent with the boundary representation curves within a specified tolerance. If all of the boundary representation curves in the face are coplanar, then conversion engine 660 determines that the boundary representation surface type for the face is planar.

If the boundary representation surface for the face for is not planar, then conversion engine 660 determines whether the boundary representation surface type is consistent with a B-spline surface, cylinder, cone, sphere, or torus, in that order. If a face is bounded by one or more cubic or quintic Bezier curves, then the boundary representation surface type will be a B-spline surface. If a face is bounded by a combination of lines and arcs, then the boundary representation surface type will be a portion of a cylinder or of a cone. For a cylinder, the radii of the arcs must be the same, the normals to the arcs must be parallel and the centers of the arcs must be aligned in the direction of the normals. Any lines must also be parallel to the normals. If the necessary conditions for a cylinder are met, conversion engine 660 determines the boundary representation surface type for the face to be a portion of a cylinder. Otherwise, conversion engine 660 determines the boundary representation surface type for the face to be a portion of a cone.

If the boundary representation surface for the face is bounded by only arcs, then conversion engine 660 defines a sphere whose center lies at the center of an arc and checks for consistency between the surface of the sphere and the remaining arcs. If the surface of the sphere is consistent with all of the arcs bounding the face, then conversion engine 660 determines the boundary representation surface type for the face to be a portion of a sphere. Otherwise, conversion engine 660 determines the boundary representation surface type for the face to be a portion of a torus with a major radius equal to the average of the two largest arcs and a minor radius equal to the smallest arc.

Conversion engine 660 combines the generated wires and surfaces to build faces. Conversion engine 660 further connects individual faces into shells and combines the shells into a single solid model.

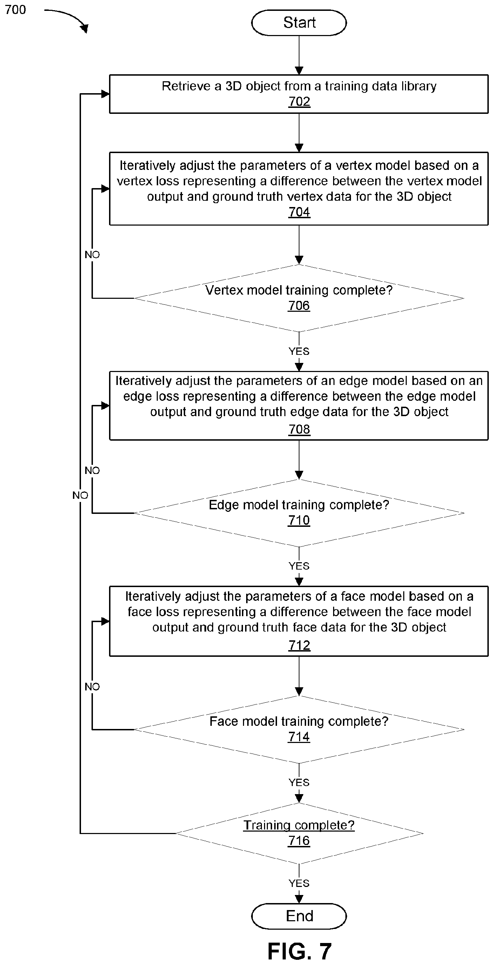

Figure 7 is a flow diagram of method steps for training a machine learning model to perform boundary representation synthesis without optional conditional data, according to some embodiments. Although the method steps are described in conjunction with the systems of Figures 1-6, persons skilled in the art will understand that any system configured to perform the method steps in any order falls within the scope of the present disclosure.

Method 700 begins at step 702, where training engine 122 retrieves a 3D object from a training data library. The 3D object is stored in the training data library in a boundary representation format, and contains ground truth data associated with the vertices, edges, and faces included in the 3D object.

At step 704, training engine 122 iteratively adjusts the parameters of a vertex model. The vertex model iteratively generates an ordered list of vertices for a 3D CAD model representation of the 3D object. At each iteration, the vertex model generates a next entry in the ordered list of vertices and the generated entry is compared to the ground truth data associated with the 3D object. Training engine 122 calculates and stores a cross-entropy vertex loss based on the difference between the generated entry and the ground truth data. Training engine 122 replaces the generated entry with the ground truth data for the 3D object such that at each time step, the vertex model generates a new entry in the ordered list of vertices based on a previous sequence of ground truth values rather than on a previous sequence of entries generated by the vertex model.

At step 706, training engine 122 determines whether the training of the vertex model is complete. If training engine 122 determines that a predetermined number of epochs have elapsed, the calculated cross-entropy loss for the validation test data has stagnated, or that the vertex model has completed generating the ordered vertex list for the 3D object, training engine 122 terminates training the vertex model on the 3D object. Otherwise, training engine 122 returns to step 704 and continues training the vertex model.

At step 708, training engine 122 iteratively adjusts the parameters of an edge model. The edge model iteratively generates an ordered list of edges for the 3D CAD model representation of the 3D object. At each iteration, the edge model generates a next entry in the ordered list of edges and the generated entry is compared to the ground truth data associated with the 3D object. Training engine 122 calculates and stores a cross-entropy edge loss based on the difference between the generated entry and the ground truth data. Training engine 122 replaces the generated entry with the ground truth data for the 3D object such that at each time step, the edge model generates a new entry in the ordered list of edges based on a previous sequence of ground truth values rather than on a previous sequence of entries generated by the edge model.

At step 710, training engine 122 determines whether the training of the edge model is complete. If training engine 122 determines that a predetermined number of epochs have elapsed, the calculated cross-entropy loss for the validation test data has stagnated, or that the edge model has completed generating the ordered edge list for the 3D object, training engine 122 terminates training the edge model on the 3D object. Otherwise, training engine returns to step 708 and continues training the edge model.

At step 712, training engine 122 iteratively adjusts the parameters of a face model. The face model iteratively generates an ordered list of faces for the 3D CAD model representation of the 3D object. At each iteration, the face model generates a next entry in the ordered list of faces and the generated entry is compared to the ground truth data associated with the 3D object. Training engine 122 calculates and stores a cross-entropy face loss based on the difference between the generated entry and the ground truth data. Training engine 122 replaces the generated entry with the ground truth data for the 3D object such that at each time step, the face model generates a new entry in the ordered list of faces based on a previous sequence of ground truth values rather than on a previous sequence of entries generated by the face model.

At step 714, training engine 122 determines whether the training of the face model is complete. If training engine 122 determines that a predetermined number of epochs have elapsed, the calculated cross-entropy loss for the validation test data has stagnated, or that the face model has completed generating the ordered face list for the 3D object, training engine 122 terminates training the face model on the 3D object. Otherwise, training engine 122 returns to step 712 and continues training the face model.

At step 716, training engine 122 determines whether the training of the vertex, edge, and face models is complete. If the termination criteria for each of the vertex, edge, and face models discussed above have all been met, or the training data library includes no further 3D objects for training, then training engine 122 terminates training. Otherwise, if the training data library includes further 3D objects for training, training engine 122 returns to step 702, retrieves a new 3D object from the training data library and continues training.

In various embodiments where training engine 122 does not apply optional conditional data to the vertex, edge, and face models, training engine 122 may train the vertex, edge, and face models simultaneously or sequentially. Further, training engine 122 may sequentially train the vertex, edge, and face models in any order.

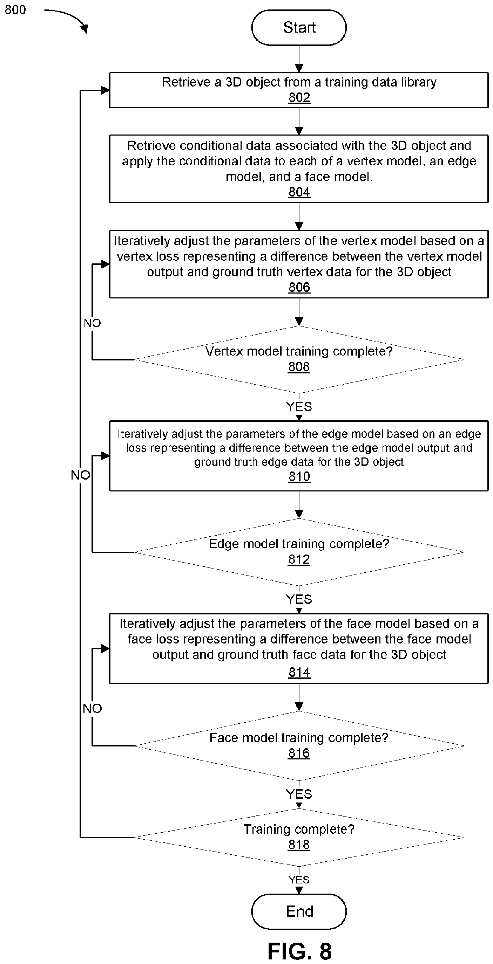

Figure 8 is a flow diagram of method steps for training a machine learning model with conditional data to perform boundary representation synthesis, according to some embodiments. Although the method steps are described in conjunction with the systems of Figures 1-6, persons skilled in the art will understand that any system configured to perform the method steps in any order falls within the scope of the present disclosure.

Method 800 begins at step 802, where training engine 122 retrieves a 3D object from a training data library. The 3D object is stored in the training data library in a boundary representation format, and contains ground truth data associated with the vertices, edges, and faces included in the 3D object.

For each 3D object in the training data library, the training data library further includes conditional data associated with the 3D object. At step 804, training engine 122 retrieves the conditional data and applies the conditional data to each of a vertex model, an edge mode, and a face model. The conditional data may include a class label for the 3D object, a 2D image representation of the 3D object, or a 3D representation of the 3D object in the form of a collection of volume elements or a point cloud. In various embodiments, the conditional data may be any data associated with the 3D object that can be represented as a vector, for example a textual description of the 3D object.

At step 806, training engine 122 iteratively adjusts the parameters of the vertex model. Guided by the conditional data, the vertex model iteratively generates an ordered list of vertices for a 3D CAD model representation of the 3D object. At each iteration, the vertex model generates a next entry in the ordered list of vertices and the generated entry is compared to the ground truth data associated with the 3D object. Training engine 122 calculates and stores a cross-entropy vertex loss based on the difference between the generated entry and the ground truth data. Training engine 122 replaces the generated entry with the ground truth data for the 3D object such that at each time step, the vertex model generates a new entry in the ordered list of vertices based on a previous sequence of ground truth values rather than on a previous sequence of entries generated by the vertex model.

At step 808, training engine 122 determines whether the training of the vertex model is complete. If training engine 122 determines that a predetermined number of epochs have elapsed, the calculated cross-entropy loss for the validation test data has stagnated, or that the vertex model has completed generating the ordered vertex list for the 3D object, training engine 122 terminates training the vertex model on the 3D object. Otherwise, training engine 122 returns to step 806 and continues training the vertex model.

At step 810, training engine 122 iteratively adjusts the parameters of the edge model. Guided by the conditional data, the edge model iteratively generates an ordered list of edges for the 3D CAD model representation of the 3D object. At each iteration, the edge model generates a next entry in the ordered list of edges and the generated entry is compared to the ground truth data associated with the 3D object. Training engine 122 calculates and stores a cross-entropy edge loss based on the difference between the generated entry and the ground truth data. Training engine 122 replaces the generated entry with the ground truth data for the 3D object such that at each time step, the edge model generates a new entry in the ordered list of edges based on a previous sequence of ground truth values rather than on a previous sequence of entries generated by the edge model.

At step 812, training engine 122 determines whether the training of the edge model is complete. If training engine 122 determines that a predetermined number of epochs have elapsed, the calculated cross-entropy loss for the validation test data has stagnated, or that the edge model has completed generating the ordered edge list for the 3D object, training engine 122 terminates training the edge model on the 3D object. Otherwise, training engine 122 returns to step 810 and continues training the edge model.

At step 814, training engine 122 iteratively adjusts the parameters of the face model. Guided by the conditional data, the face model iteratively generates an ordered list of faces for a 3D CAD model representation of the 3D object. At each iteration, the face model generates a next entry in the ordered list of faces and the generated entry is compared to the ground truth data associated with the 3D object. Training engine 122 calculates and stores a cross-entropy face loss based on the difference between the generated entry and the ground truth data. Training engine 122 replaces the generated entry with the ground truth data for the 3D object such that at each time step, the face model generates a new entry in the ordered list of faces based on a previous sequence of ground truth values rather than on a previous sequence of entries generated by the face model.

At step 816, training engine 122 determines whether the training of the face model is complete. If training engine 122 determines that a predetermined number of epochs have elapsed, the calculated cross-entropy loss for the validation test data has stagnated, or that the face model has completed generating the ordered face list for the 3D object, training engine 122 terminates training the face model on the 3D object. Otherwise, training engine 122 returns to step 814 and continues training the face model.

At step 818, training engine 122 determines whether the training of the vertex, edge, and face models is complete. If the termination criteria discussed above for each of the vertex, edge, and face models have all been met, or the training data library includes no further 3D objects for training, then training engine 122 terminates training. Otherwise, if the training data library includes further 3D objects for training, training engine 122 returns to step 802, retrieves a new 3D object from the training data library and continues training.

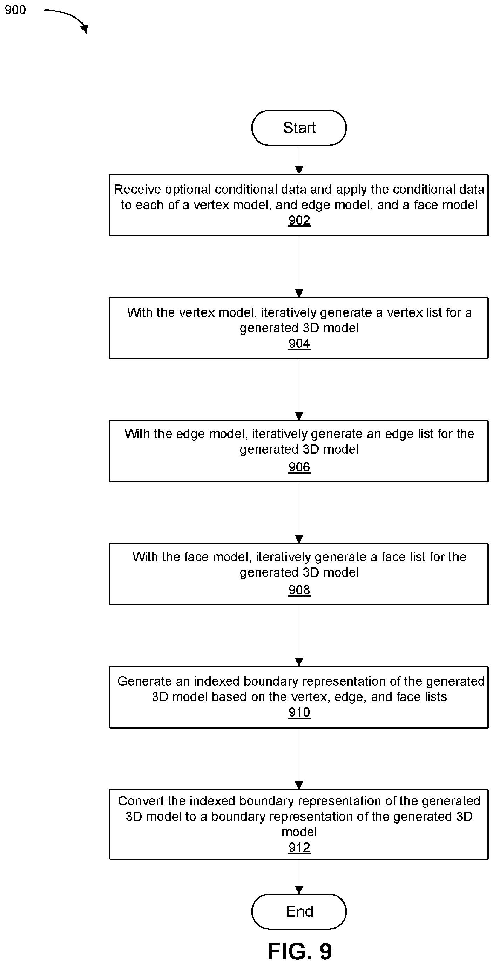

Figure 9 is a flow diagram of method steps for generating a 3D model in boundary representation format, according to some embodiments. Although the method steps are described in conjunction with the systems of Figures 1-6, persons skilled in the art will understand that any system configured to perform the method steps in any order falls within the scope of the present disclosure.

Method 900 begins at step 902, where inference engine 124 optionally receives conditional data and, if received, applies the conditional data to each of a vertex model, edge model, and face model.

At step 904, inference engine 124 generates, with the vertex model, an ordered vertex list for a generated 3D CAD model. Optionally guided by the conditional data, the vertex model iteratively generates the ordered vertex list until the vertex model terminates the generated vertex list with an end of sequence token. The vertex model transmits the ordered vertex list to each of the edge and face models.

At step 906, inference engine 124 generates, with the edge model, an ordered edge list for the generated 3D CAD model. Based on the ordered vertex list from the vertex model and optionally guided by the conditional data, the edge model iteratively generates the ordered edge list until the edge model terminates the generated edge list with an end of sequence token. The edge model transmits the ordered edge list to the face model.

At step 908, inference engine 124 generates, with the face model, an ordered face list for the generated 3D CAD model. Based on the ordered vertex and edges lists from the vertex and edge models and optionally guided by the conditional data, the face model iteratively generates the ordered face list until the face model terminates the generated face list with an end of sequence token.

At step 910, inference engine 124 generates an indexed boundary representation of the generated 3D CAD model based on the ordered vertex, edge, and face lists generated by the vertex, edge, and face models, respectively. The indexed boundary representation includes the ordered vertex list, the ordered edge list, with each edge in the list defined by indices into the vertex list, and the face list, with each face in the list defined by indices into the edge list.

At step 912, inference engine 124 converts the indexed boundary representation of the generated 3D CAD model into a boundary representation of the generated 3D CAD model. Inference engine 124 applies heuristic algorithms to the indexed boundary representation to determine vertices, edges, wires, and surfaces in boundary representation format for the generated 3D CAD model.

In sum, the disclosed techniques train and execute a machine learning model to generate a 3D CAD model in indexed boundary format representation. The machine learning model further applies heuristic algorithms to convert the indexed boundary representation of the 3D CAD model into a boundary representation of the 3D CAD model.

The machine learning model includes a vertex model that iteratively generates an ordered list of vertices for the 3D CAD model by selecting, at each iteration, a next vertex coordinate from a probability distribution over a set of possible coordinates. The machine learning model further includes an edge model that iteratively generates an ordered list of edges for the 3D CAD model by selecting, at each iteration, a vertex from the ordered list of vertices generated by the vertex model. Each edge in the ordered list of edges is defined by references to the vertices in the vertex list that form the edge. The machine learning model further includes a face model that iteratively generates an ordered list of faces by the 3D CAD model by selecting, at each iteration, an edge from the ordered list of edges generated by the edge model. Each face in the ordered list of faces is defined by references to edges in the edge list that form the face. The disclosed techniques combine the ordered vertex, edge, and face lists to form an indexed boundary representation of the generated 3D CAD model.

The machine learning model applies heuristic rules to the indexed boundary representation of the 3D CAD model to convert the indexed boundary representation into a boundary representation. These heuristic rules determine whether an edge in the boundary representation is a line, an arc, or a Bezier curve, and further determine whether the surface for a face in the boundary representation is a B-spline surface or a portion of a plane, a sphere, a cylinder, a cone, or a torus.

During training or inference, the machine learning model may optionally apply conditional input data to the vertex, edge, and face models. The conditional input data may be a class label, a 2D image, or a 3D representation such as a collection of volume elements or a point cloud. During training, the conditional input data associated with a 3D object in a training data library is applied to the vertex, edge, and face models to guide the generation of vertex, edge, and face lists. During inference, the conditional input data guides the machine learning model in the generation of a 3D CAD model by guiding the vertex, edge, and face models.

One technical advantage of the disclosed technique relative to the prior art is that the disclosed technique does not rely on training data that includes both CAD models and the series of CAD modeling operations used to generate the CAD models. As a result, there is a larger quantity of CAD model training data available suitable for training the disclosed technique. The disclosed technique also generates boundary representations directly without the need to first predict and generate a series of CAD modeling operations. Because the disclosed technique generates boundary representations directly, the disclosed technique can incorporate operations such as fillets and chamfers that require pre-existing boundary representation edges. Another advantage of the disclosed technique is that the disclosed technique is not limited to 2D planar curves. The disclosed technique supports Bezier curves and complex curved surfaces such as B-spline surfaces.
1. In some embodiments, a computer-implemented method of generating a three-dimensional (3D) CAD model comprises generating, using a first machine learning model, a vertex list that includes an ordered list of vertex coordinates, generating, using a second machine learning model, an edge list that includes an ordered list of edges, wherein one or more elements of the edge list include references to elements of the vertex list, generating, using a third machine learning model, a face list that includes an ordered list of faces, wherein one or more elements of the face list include references to elements of the edge list, and generating, based on the vertex list, the edge list, and the face list, an indexed boundary representation for a 3D CAD model.
2. The computer-implemented method of clause 1, wherein the indexed boundary representation includes the vertex list, the edge list, with each edge in the edge list defined by indices into the vertex list, and the face list, with each face in the face list defined by indices into the edge list.
3. The computer-implemented method of clauses 1 or 2, further comprising converting the indexed boundary representation of the 3D CAD model into a boundary representation (B-rep) of the 3D CAD model.
4. The computer-implemented method of any of clauses 1-3, further comprising determining, for an edge in the edge list of the indexed boundary representation, a boundary representation edge type for an associated edge in the B-rep of the 3D CAD model, wherein the boundary representation edge type is one of a line, an arc, a cubic Bezier curve, or a quintic Bezier curve, and determining, for a face in the face list of the indexed boundary representation, a boundary representation surface type for an associated face in the B-rep of the 3D CAD model, wherein the boundary representation surface type is a B-spline surface or a portion of one of a cylinder, a cone, a sphere, or a torus.
5. The computer-implemented method of any of clauses 1-4, further comprising applying conditional input data to each of the first machine learning model, the second machine learning model, and the third machine learning model.
6. The computer-implemented method of any of clauses 1-5, wherein the conditional input data is a class label.
7. The computer-implemented method of any of clauses 1-6, wherein the conditional input data is one of a two-dimensional (2D) image, a 3D collection of volume elements, or a 3D point cloud.
8. The computer-implemented method of any of clauses 1-7, further comprising determining, for each element in the vertex list, a positional embedding associated with the element of the vertex list, applying the positional embedding associated with each element of the vertex list to the first machine learning model, determining, for each element in the edge list, a positional embedding associated with the element of the edge list, applying the positional embedding associated with each element of the edge list to the second machine learning model, determining, for each element in the face list, a positional embedding associated with the element of the face list, and applying the positional embedding associated with each element of the face list to the third machine learning model.
9. The computer-implemented method of any of clauses 1-8, further comprising determining, for each element in the vertex list, a coordinate embedding associated with the element of the vertex list, applying the coordinate embedding associated with each element of the vertex list to the first machine learning model, determining, for each element in the vertex list, a value embedding associated with the element of the vertex list, and applying the value embedding for associated with element of the vertex list to the first machine learning model.
10. In some embodiments, one or more non-transitory computer-readable media store instructions that, when executed by one or more processors, cause the one or more processors to perform the steps of generating, using a first machine learning model, a vertex list that includes an ordered list of vertex coordinates, generating, using a second machine learning model, an edge list that includes an ordered list of edges, wherein one or more elements of the edge list include references to elements of the vertex list, generating, using a third machine learning model, a face list that includes an ordered list of faces, wherein one or more elements of the face list include references to elements of the edge list, and generating, based on the vertex list, the edge list, and the face list, an indexed boundary representation for a 3D CAD model.
11. The one or more non-transitory computer-readable media of clause 10, wherein the indexed boundary representation includes the vertex list, the edge list, with each edge in the edge list defined by indices into the vertex list, and the face list, with each face in the face list defined by indices into the edge list.
12. The one or more non-transitory computer-readable media of clauses 10 or 11, wherein the instructions further cause the one or more processors to perform the step of converting the indexed boundary representation of the 3D CAD model into a boundary representation (B-rep) of the 3D CAD model.
13. The one or more non-transitory computer-readable media of any of clauses 10-12, wherein the instructions further cause the one or more processors to perform the steps of determining, for an edge in the edge list of the indexed boundary representation, a boundary representation edge type for an associated edge in the B-rep of the 3D CAD model, wherein the boundary representation edge type is one of a line, an arc, a cubic Bezier curve, or a quintic Bezier curve, and determining, for a face in the face list of the indexed boundary representation, a boundary representation surface type for an associated face in the B-rep of the 3D CAD model, wherein the boundary representation surface type is a B-spline surface or a portion of one of a cylinder, a cone, a sphere, or a torus.
14. The one or more non-transitory computer-readable media of any of clauses 10-13, wherein the instructions further cause the one or more processors to perform the step of applying conditional input data to each of the first machine learning model, the second machine learning model, and the third machine learning model.
15. The one or more non-transitory computer-readable media of any of clauses 10-14, wherein the conditional input data is a class label.
16. The one or more non-transitory computer-readable media of any of clauses 10-15, wherein the conditional input data is one of a two-dimensional (2D) image, a 3D collection of volume elements, or a 3D point cloud.
17. The one or more non-transitory computer-readable media of any of clauses 10-16, wherein the instructions further cause the one or more processors to perform the steps of determining, for each element in the vertex list, a positional embedding associated with the element of the vertex list, applying the positional embedding associated with each element of the vertex list to the first machine learning model, determining, for each element in the edge list, a positional embedding associated with the element of the edge list, applying the positional embedding associated with each element of the edge list to the second machine learning model, determining, for each element in the face list, a positional embedding associated with the element of the face list, and applying the positional embedding associated with each element of the face list to the third machine learning model.
18. The one or more non-transitory computer-readable media of any of clauses 10-17, wherein the instructions further cause the one or more processors to perform the steps of determining, for each element in the vertex list, a coordinate embedding associated with the element of the vertex list, applying the coordinate embedding associated with each element of the vertex list to the first machine learning model, determining, for each element in the vertex list, a value embedding associated with the element of the vertex list, and applying the value embedding associated with each element of the vertex list to the first machine learning model.
19. In some embodiments, a system comprises one or more memories storing instructions, and one or more processors for executing the instructions to generate, using a first machine learning model, a vertex list that includes an ordered list of vertex coordinates, generate, using a second machine learning model, an edge list that includes an ordered list of edges, wherein one or more elements of the edge list include references to elements of the vertex list, generate, using a third machine learning model, a face list that includes an ordered list of faces, wherein one or more elements of the face list include references to elements of the edge list, and generate, based on the vertex list, the edge list, and the face list, an indexed boundary representation for a 3D CAD model.
20. The system of clause 19, wherein the indexed boundary representation includes the vertex list, the edge list, with each edge in the edge list defined by indices into the vertex list, and the face list, with each face in the face list defined by indices into the edge list.

Any and all combinations of any of the claim elements recited in any of the claims and/or any elements described in this application, in any fashion, fall within the contemplated scope of the present invention and protection.

The descriptions of the various embodiments have been presented for purposes of illustration but are not intended to be exhaustive or limited to the embodiments disclosed. Many modifications and variations will be apparent to those of ordinary skill in the art without departing from the scope and spirit of the described embodiments.

Aspects of the present embodiments may be embodied as a system, method or computer program product. Accordingly, aspects of the present disclosure may take the form of an entirely hardware embodiment, an entirely software embodiment (including firmware, resident software, micro-code, etc.) or an embodiment combining software and hardware aspects that may all generally be referred to herein as a "module," a "system," or a "computer." In addition, any hardware and/or software technique, process, function, component, engine, module, or system described in the present disclosure may be implemented as a circuit or set of circuits. Furthermore, aspects of the present disclosure may take the form of a computer program product embodied in one or more computer readable medium(s) having computer readable program code embodied thereon.

Any combination of one or more computer readable medium(s) may be utilized. The computer readable medium may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples (a non-exhaustive list) of the computer readable storage medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain, or store a program for use by or in connection with an instruction execution system, apparatus, or device.

Aspects of the present disclosure are described above with reference to flowchart illustrations and/or block diagrams of methods, apparatus (systems) and computer program products according to embodiments of the disclosure. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus to produce a machine. The instructions, when executed via the processor of the computer or other programmable data processing apparatus, enable the implementation of the functions/acts specified in the flowchart and/or block diagram block or blocks. Such processors may be, without limitation, general purpose processors, special-purpose processors, application-specific processors, or field-programmable gate arrays.

The flowchart and block diagrams in the figures illustrate the architecture, functionality, and operation of possible implementations of systems, methods and computer program products according to various embodiments of the present disclosure. In this regard, each block in the flowchart or block diagrams may represent a module, segment, or portion of code, which comprises one or more executable instructions for implementing the specified logical function(s). It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts, or combinations of special purpose hardware and computer instructions.

While the preceding is directed to embodiments of the present disclosure, other and further embodiments of the disclosure may be devised without departing from the basic scope thereof, and the scope thereof is determined by the claims that follow.

## Claims

1. A computer-implemented method of generating a three-dimensional, 3D, CAD model of a 3D object, the computer-implemented method comprising:
a) generating, using a first machine learning model, a vertex list that includes an ordered list of vertex coordinates;
b) generating, using a second machine learning model, an edge list that includes an ordered list of edges, wherein one or more elements of the edge list include references to elements of the vertex list;
c) generating, using a third machine learning model, a face list that includes an ordered list of faces, wherein one or more elements of the face list include references to elements of the edge list;
d) generating, based on the vertex list, the edge list, and the face list, an indexed boundary representation for a 3D CAD model; and
e) converting the indexed boundary representation of the 3D CAD model into a boundary representation, B-rep, of the 3D CAD model.

2. The computer-implemented method of claim 1, wherein the indexed boundary representation includes the vertex list, the edge list, with each edge in the edge list defined by indices into the vertex list, and the face list, with each face in the face list defined by indices into the edge list.

3. The computer-implemented method of any preceding claim, further comprising:
determining, for an edge in the edge list of the indexed boundary representation, a boundary representation edge type for an associated edge in the B-rep of the 3D CAD model, wherein the boundary representation edge type is one of a line, an arc, a cubic Bezier curve, or a quintic Bezier curve; and
determining, for a face in the face list of the indexed boundary representation, a boundary representation surface type for an associated face in the B-rep of the 3D CAD model, wherein the boundary representation surface type is a B-spline surface or a portion of one of a cylinder, a cone, a sphere, or a torus.

4. The computer-implemented method of any preceding claim, further comprising applying conditional input data to each of the first machine learning model, the second machine learning model, and the third machine learning model.

5. The computer-implemented method of claim 4, wherein the conditional input data is a class label.

6. The computer-implemented method of claim 4 or 5, wherein the conditional input data is one of a two-dimensional (2D) image, a 3D collection of volume elements, or a 3D point cloud.

7. The computer-implemented method of any preceding claim, further comprising:
determining, for each element in the vertex list, a positional embedding associated with the element of the vertex list;
applying the positional embedding associated with each element of the vertex list to the first machine learning model;
determining, for each element in the edge list, a positional embedding associated with the element of the edge list;
applying the positional embedding associated with each element of the edge list to the second machine learning model;
determining, for each element in the face list, a positional embedding associated with the element of the face list; and
applying the positional embedding associated with each element of the face list to the third machine learning model.

8. The computer-implemented method of any preceding claim, further comprising:
determining, for each element in the vertex list, a coordinate embedding associated with the element of the vertex list;
applying the coordinate embedding associated with each element of the vertex list to the first machine learning model;
determining, for each element in the vertex list, a value embedding associated with the element of the vertex list; and
applying the value embedding for associated with element of the vertex list to the first machine learning model.

9. The computer-implemented method of any preceding claim wherein steps a, b and c are based on ground truth data associated with the 3D object.

10. A computer program product comprising instructions that, when executed by one or more processors, cause the one or more processors to perform the steps of the method of any preceding claim.

11. A system comprising:
one or more memories storing instructions; and
one or more processors for executing the instructions to carry out the method of any of claims 1 to 9.
